**Europäisches Patentamt**

**European Patent Office**

**Office européen des brevets**

(19)

(11) Numéro de publication: **0 195 041**

**B1**

(12)

# FASCICULE DE BREVET EUROPÉEN

(45) Date de publication du fascicule du brevet:
14.12.88

(51) Int. Cl.⁴: **B 05 B 5/00**

(21) Numéro de dépôt: 85904840.1

(22) Date de dépôt: 18.09.85

(86) Numéro de dépôt international:
PCT/FR 85/00253

(87) Numéro de publication internationale:
WO 86/01745 (27.03.86 Gazette 86/07)

(54) **PROCEDE ET DISPOSITIF DE DEPOT ELECTROSTATIQUE DE PRODUITS LIQUIDES SUR DES SUBSTRATS.**

(30) Priorité: 18.09.84 FR 8414475

(43) Date de publication de la demande:
24.09.86 Bulletin 86/39

(45) Mention de la délivrance du brevet:
14.12.88 Bulletin 88/50

(84) Etats contractants désignés:
AT BE CH DE FR GB IT LI LU NL SE

(56) Documents cité:
DE-A-2 546 025
GB-A-1 126 539
US-A-3 680 779

(73) Titulaire: DE MOUVEAUX, Pierre, Rue de Lyon 112,
CH- 1203 Geneve (CH)

(72) Inventeur: DE MOUVEAUX, Pierre, Rue de Lyon
112, CH- 1203 Geneve (CH)

EP 0 195 041 B1

LIBER, STOCKHOLM 1988

## Description

La présente invention a pour objet un procédé pour l'application des produits liquides sur un substrat suivant le préambule de la revendication 1.

L'invention a également pour objet une installation pour la mise en oeuvre de ce procédé, suivant le préambule de la revendication 5.

L'application de résines synthétiques sur des éléments électroniques, circuits imprimés ou autres, en couches extrêmement minces et, surtout, très régulières, pose des problèmes qui n'ont jamais été résolus de façon satisfaisante.

Les moyens mis en oeuvre jusqu'à présent non seulement ne donnent guère satisfaction quant au résultat de l'opération mais encore sont encombrants, ne permettent pas un automatisme total, conduisent à une consommation exagérée du produit et n'offrent pas une garantie suffisante quant à la sécurité de fonctionnement, en particulier vis-à-vis des risques de pollution.

Le but de la présente invention est de remédier à ces inconvénients en fournissant un moyen d'appliquer sur un substrat constituant un élément d'un composant électronique une couche mince et régulière de résine synthétique liquide.

Le procédé suivant l'invention est caractérisé par les caractéristiques mentionnées dans la partie caractérisante de la revendication 1.

Quant à l'installation suivant l'invention pour la mise en oeuvre de ce procédé, elle est caractérisée par les caractéristiques mentionnées dans la partie caractérisante de la revendication 5.

Il est à remarquer que l'on connaît (cf. brevet anglais No 1 126 539, sur lequel les préambules des revendications indépendantes 1 et 5 sont basés), des installations permettant de déposer des produits chimiques en couches minces sur un substrat formé d'une bande de papier ou de tout matériau analogue en nappe, par atomisation du produit de revêtement, et ceci au travers d'un champ électrostatique. On traite, dans l'installation décrite et représentée dans ce brevet, un ruban et non pas des pièces individuelles comme dans la présente invention. De plus, les produits appliqués sont des colles, des apprêts, des imperméabilisants qui ne présentent pas du tout les mêmes difficultés, pour être appliqués en couches minces , que celles que présente l'application de résine synthétique et, de surcroît, sur des substrats utilisés dans l'électronique. En effet, ces substrats ne sont aucunement absorbants alors qu'au contraire les matériaux traités dans le brevet anglais le sont, ce qui, bien entendu, modifie complètement les conditions de travail.

On a également utilisé le principe de la pulvérisation dans un champ électrostatique (cf. brevet USA No 3 680 779) pour l'application de poudres sur des substrats, et ceci dans les arts graphiques.

La encore, les problèmes posés par l'application de poudres ne sont pas les mêmes que ceux que présente l'application, en couches minces et régulières, de résine synthétique se présentant, au départ, sous forme liquide.

Le dessin représente, à titre d'exemple, une forme d'exécution d'une installation permettant l'application, en couche mince et régulière, sur un substrat constituant un élément d'un composant électronique, d'une résine synthétique liquide.

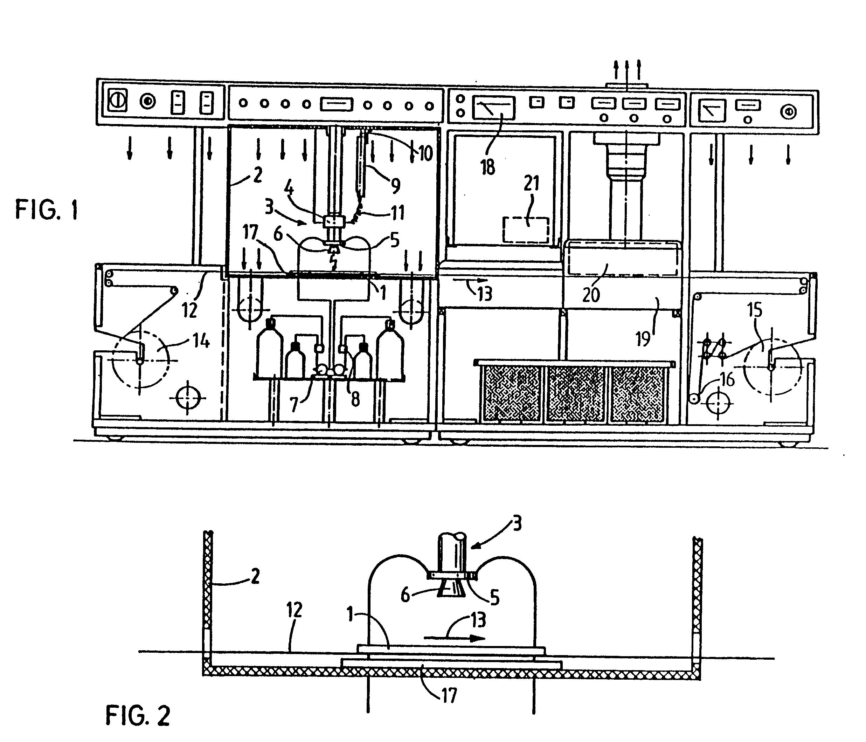

La fig. 1 est une vue en élévation, schématique, avec coupe partielle, d'une telle installation, représentée dans son ensemble et,

La fig. 2 est une vue d'un détail de la fig. 1 , à plus grande échelle.

L'installation représentée est destinée à l'application, sur un substrat 1, d'une couche mince et régulière de résine synthétique, en particulier de résine photosensible, liquide.

A cet effet, l'installation comprend, logé dans une cage 2, et désigné d'une façon générale par 3, un pulvérisateur comprenant une turbine pneumatique à haute vitesée 4), un distributeur de produit 5, présentant des injecteurs, et un atomiseur rotatif 6, en forme de cône. Le produit liquide est distribué à l'aide de micro-pompes 7, situées à l'extérieur de la cage 2, par des circuits comprenant des vannes à trois voies 8 permettant de faire circuler alternativement le produit à pulvériser et des solvants de nettoyage.

L'installation comprend, logé à l'intérieur de la cage 2, un générateur de courant à haute tension 9 dont une borne est reliée en 10 à la cage et dont l'autre borne est reliée en 11 au pulvérisateur 3.

Les pièces à traiter, dont une seule a été représentée en 1 au dessin, sont placées sur un ruban transporteur 12, en papier, qui se déplace dans la direction de la flèche 13 en traversant la cage 2. Ce ruban 12 est enroulé sur une bobine débitrice 14 et s'enroule sur une bobine receptrice 15, non sans avoir, auparavant, passé sur un dispositif à boucle libre 16. Une électrode 17, en contact avec la cage 2 sur le fond de laquelle elle repose, est située dans l'axe de pulvérisation.

Ainsi, les pièces à traiter, lors de leur passage en regard du pulvérisateur 3, sont-elles mises à une polarité inverse de celle du pulvérisateur, c'est-à-dire de celle des particules de la résine synthétique à appliquer, et ceci sans entrer en contact matériel avec l'électrode 17.

L'installation comprend en outre un dispositif 18 de contrôle et de sécurité de la haute tension, des postes de séchage et d'étuvage 19 comprenant des émetteurs 20 de rayons infrarouges dont la régulation est assurée par des triacs indiqués en 21. Il est à remarquer que d'autres modes de séchage et d'étuvage pourront aussi entrer en ligne de compte.

Afin d'assurer une parfaite régularité dans l'épaisseur des couches de matériau appliquées sur les substrats, l'entraînement du ruban de papier 12 sera réalisé à vitesse constante, indépendante des diamètres des bobines émettrice et réceptrice.

Ainsi, le présent procédé, qui consiste à faire défiler les pièces à traiter dans un champ électrostatique à l'intérieur d'une cage en les plaçant à une polarité inverse de celle de la matière à appliquer, que l'on pulvérise sur lesdites pièces, permet de traiter des pièces de toute forme et de tout relief et d'obtenir des couches extrêmement minces et tout à fait régulières, conformément aux exigences en matière d'électronique.

La présente installation pourra aisément être automatisée; elle est d'un encombrement réduit et fonctionne sans produire de pollution, ce qui permet de l'utiliser dans des salles dites "propres", telles que des laboratoires de fabrication d'éléments électroniques, par exemple.

## Revendications

1. Procédé pour l'application des produits liquides sur un substrat (1) à l'aide d'un pulvérisateur (3), alors que le substrat (1 ) se déplace sensiblement perpendiculairement à la direction du pulvérisateur dans un champ électrostatique, créé par un générateur de courant à haute tension (9),
caractérisé en ce
qu'on pulvérise une résine synthètique liquide photosensible en direction du substrat (1) non absorbant au regard de cette résine; en ce que ce procédé est appliqué sur des substrats (1) utilisés dans la fabrication d'éléments individuels de composants électroniques ou de circuits imprimés; ce substrat (1) étant supporté par une bande transporteuse (12) passant à travers une cage (2) au dessus d'une électrode (17) du dispositif électrostatique, laquelle électrode (17) est posée sur le fond de la cage (2), et
en ce que l'électrode est mise à la masse et le pulvérisateur est mis à l'autre borne du générateur de courant (9), cette borne ayant une polarité inverse de l'électrode (17), et
en ce qu'on dépose les particules sur le substrat (1) en les laissant y adhérer.

2. Procédé suivant la revendication 1, caractérisé par le fait qu'on utilise un ruban de papier comme moyen de transport du substrat, l'amenant à traverser le champ électrostatique.

3. Procédé suivant la revendication 2, caractérisé par le fait qu'on place une électrode sous ledit ruban transporteur, que l'on relie à l'une des bornes d'un générateur de courant à haute tension, de manière à polariser le substrat sans que celui-ci soit en contact matériel avec ladite électrode, le dispositif de pulvérisation de la résine synthétique liquide étant relié à l'autre borne dudit générateur à haute tension.

4. Procédé suivant la revendication 3, caractérisé par le fait qu'on place le pulvérisateur et ladite électrode à l'intérieur d'une cage.

5. Installation pour la mise en oeuvre du procédé suivant la revendication 1, comprennant un pulvérisateur (3), un générateur (9) de courant à haute tension dont une borne est reliée audit pulvérisateur et l'autre à une électrode située sous un transporteur amenant sur un ruban (12) le substrat (1) à travers un champ électrostatique entre le pulvérisateur (3) et l'électrode (17),
caractérisé en ce que le pulvérisateur (3), le générateur (9) et le ruban (12) portant le substrat (1) à traiter sont logés, au moins en partie, dans un entourage formant une cage (2).

## Patentansprüche

1. Verfahren zum Aufbringen von Flüssigkeiten auf ein Substrat (1) mit Hilfe einer Sprühvorrichtung (3), wenn sich das Substrat im wesentlichen senkrecht zur Richtung der Sprühvorrichtung in einem elektrostatischen Feld bewegt, das durch einen Hochspannungsgenerator (9) erzeugt wird, dadurch gekennzeichnet,
- daß eine lichtempfindliche Kunstharzflüssigkeit in Richtung des Substrates (1) gesprüht wird, das in Bezug auf dieses Harz nicht absorbierend ist,
- daß dieses Verfahren bei Substraten (1) angewendet wird, welche bei der Herstellung von individuellen Elementen von elektronischen Komponenten oder von gedruckten Schaltungen verwendet werden, wobei das Substrat (1) durch ein Transportband (12) getragen wird, welches einen Käfig (2) oberhalb einer Elektrode (17) der elektrostatischen Vorrichtung durchquert, wobei diese Elektrode (17) auf dem Boden des Käfigs (2) angeordnet ist,
- daß die Elektrode an Masse angeschlossen ist und die Sprühvorrichtung mit dem anderen Anschluß des Stromgenerators (9) verbunden ist, wobei dieser Anschluß eine Polarität aufweist, die umgekehrt zu der der Elektrode (17) ist, und
- daß die Partikel so auf das Substrat (1) aufgebracht werden, daß sie dort anhaften.

2. Verfahren nach Anspruch 1, dadurch gekennzeichnet, daß ein Papierband als Transportmittel für das Substrat verwendet wird, um dieses durch das elektrostatische Feld zu führen.

3. Verfahren nach Anspruch 2, dadurch gekennzeichnet, daß unter dem besagten Bandförderer eine Elektrode angeordnet ist, die mit einem der Anschlüsse eines Hochspannungsgenerators verbunden ist so, daß das Substrat polarisiert wird, ohne daß es in materiellem Kontakt mit der besagten Elektrode steht, wobei die Sprühvorrichtung der Kunstharzflüssigkeit mit dem anderen Anschluß des besagten Hochspannungsgenerators verbunden ist.

4. Verfahren nach Anspruch 3, dadurch gekennzeichnet, daß die Sprühvorrichtung und die Elektrode im Inneren des Käfigs angeordnet sind.

5. Vorrichtung zur Durchführung des Verfahrens nach Anspruch 1, umfassend: eine Sprühvorrichtung (3), einen Hochspannungsgenerator (9), dessen einer Anschluß mit der Sprühvorrichtung und der andere mit einer Elektrode verbunden ist, welche unter einem Förderer angeordnet ist, der auf einem Band (12) das Substrat (1) durch ein elektrostatisches Feld zwischen der Sprühvorrichtung (3) und der Elektrode (17) mitnimmt,

dadurch gekennzeichnet, daß die Sprühvorrichtung (3), der Generator (9) und das das zu behandelnde Substrat (1) tragende Band (12) zumindest teilweise in einem einen Käfig (2) bildenden Raum angeordnet sind.

## Claims

1. Method to apply liquid products on a substrate (1) through a sprayer (3) whereas the substrate (1) is moving substantially perpendicularly to the direction of the sprayer in an electrostatic field, created by a high voltage current generator (9), characterized in that a photosensitive liquid resist is sprayed towards the substrate (1) non absorbent towards the resist;

in that this method is applied on substrates (1) used in manufacturing separate elements of electronic components or printed circuits; this substrate (1) being carried by a conveyor belt (12) going through a cage (2) above an electrode (17) of the electrostatic device, which electrode (17) is placed at the bottom of the cage (2), and

in that the electrode is grounded and the sprayer is connected to the other terminal of the current generator (9), this terminal having a reciprocal polarity of the electrode (17), and

in that the particles are deposited on the substrate (1) while letting them adhering to the substrate.

2. Method according to the claim 1, characterized by the fact that a paper web is used as conveyor mean of the substrate, driving it through the electrostatic field.

3. Method according to the claim 2, characterized by the fact that an electrode is placed under the said conveyor web, which is connected to one of the terminals of the high voltage current generator, in order to polarize the substrate without it is in physical contact with the said electrode, the device of spraying the synthetic resist being connected to the other terminal of the said high voltage generator.

4. Method according to the claim 3, characterized by the fact that the sprayer and the said electrode are placed in the inside of a cage.

5. Equipment for carrying out the method according to the claim 1, including a sprayer (3), a high voltage current generator (9) one terminal of which is connected to the said sprayer and the other one to an electrode placed under a conveyor which drives the substrate (1) on a web (12) through an electrostatic field between the sprayer (3) and the electrode (17), characterized in that the sprayer (3), the generator (9) and the web (12) carrying the substrate (1) to be treated are located, at least partially, in a surrounding element constituting a cage (2).

FIG. 1

FIG. 2